Europäisches Patentamt

European Patent Office

Office européen des brevets

(11) Veröffentlichungsnummer: **0 457 346 A1**

## (12) EUROPÄISCHE PATENTANMELDUNG

(21) Anmeldenummer: 91108034.9

(51) Int. Cl.5: **H05K 3/34**

(22) Anmeldetag: 17.05.91

(30) Priorität: 18.05.90 DE 4016107

(43) Veröffentlichungstag der Anmeldung:
21.11.91 Patentblatt 91/47

(84) Benannte Vertragsstaaten:
AT BE CH DE DK ES FR GB GR IT LI LU NL SE

(71) Anmelder: **Friedrich, Dieter, Dr.-Ing.**
**Flurstrasse 8**
**W-8501 Eckental(DE)**

Anmelder: **Friedrich, Gitta**
**Flurstrasse 8**
**W-8501 Eckental(DE)**

(72) Erfinder: **Friedrich, Dieter, Dr.-Ing.**
**Flurstrasse 8**
**W-8501 Eckental(DE)**
Erfinder: **Friedrich, Gitta**
**Flurstrasse 8**
**W-8501 Eckental(DE)**

(74) Vertreter: **Hafner, Dieter et al**
**Dipl.-Phys. Dr. D. Hafner - Dipl.-Ing. H. Stippl**
**Ostendstrasse 132**
**W-8500 Nürnberg 30(DE)**

(54) Verfahren zum Tauchbeloten von Leiterplatten.

(57) Die Erfindung betrifft ein Verfahren zum Herstellen von Leiterplatten mit mit einem Lotauftrag zu versehenden Lotpads, die zunächst mit einer eine Belotung verhindernden Begrenzungsschicht definierter Dicke umgeben werden; sodann wird die Leiterplatte in ein Lotbad eingebracht, in dem die zu belotenden Bereiche mit einem Abschlußelement abgedeckt werden; beim Ausbringen der Leiterplatte aus dem Bad herausgebracht wird durch die Abdeckung eine Trennung der eingeschlossenen Lotvolumina von dem im Tauchbad oder in der Lotkammer befindlichen flüssigen Lot erzielt, dabei werden in den über den Lotpads befindlichen Hohlräumen entsprechende Lotvolumina definiert. Dies hat den Vorteil gegenüber dem Stand der Technik, daß die Abdeckung mit vereinfachten Mitteln durchführbar ist und der Formprozeß der Lotpads losgelöst vom eigentlichen Tauchbelotungsvorgang durchgeführt werden kann.

EP 0 457 346 A1

Fig. 1

EP 0 457 346 A1

Die Erfindung betrifft ein Verfahren zum Tauchbeloten von Leiterplatten sowie eine Vorrichtung zum Tauchbeloten von Leiterplatten mit einer den Lotauftrag seitlich definierenden Begrenzungsschicht.

Aus der europäischen Patentanmeldung EP-OS 0 336 232 ist ein Verfahren zum Tauchbeloten von Leiterplatten bekannt, bei dem i. w. folgende Verfahrensschritte ablaufen:

a) Herstellen einer Leiterplatte mit elektrisch leitfähigen Bereichen (Lotpads), die mit einem Lotauftrag zu versehen sind;

b) Umgrenzen dieser Bereiche mit einer eine Belotung erhindernden Begrenzungsschicht definierter Schichtdicke, welche i. w. der Höhe des zu erzeugenden Lotauftrages entspricht;

c) Eintauchen der so vorbereiteten Leiterplatte in ein Lotbad mit geeigneter Lotlegierung;

d) Abdecken der zu belotenden Bereiche mit einem Abschlußelement unter definiertem Anpreßdruck;

e) Austauchen der abgedeckten Leiterplatte aus dem Lotbad und nachfolgendes Unterschreiten der Erstarrungstemperatur der Lotlegierung in abgedecktem Zustand, wodurch eine Formgebung der Lotaufträge erfolgt;

f) Abschließend werden das Abschlußelement und die Begrenzungsschicht entfernt.

Der Abdichtungs- und Formgebungsvorgang läuft bei dem bekannten Verfahren i. w. gleichzeitig ab, was an sich zu hervorragenden Verfahrensergebnissen führt, aber hinsichtlich einer gleichmäßig guten Abdichtung in Verbindung mit einer gleichmäßig guten Oberflächenausbildung der Lotpads nicht unproblematisch ist. Außerdem treten apparative Schwierigkeiten auf, wenn die zumindest teilweise im Lotbad befindliche Abdichtvorrichtung gleichzeitig den Lotpad-Oberflächen-Formprozeß durchführen und deswegen die Abdeckung auch während der gesamten Abkühlphase aufrechterhalten bleiben muß.

Der Erfindung liegt die Aufgabe zugrunde, das Verfahren nach dem Stand der Technik derart weiterzubilden, daß die Abdeckung mit vereinfachten Mitteln durchführbar ist und der Formprozeß der Lotpads losgelöst vom eigentlichen Tauchbelotungsprozeß durchgeführt werden kann. Diese Aufgabe wird dadurch gelöst, daß der Abdeckungsprozeß nur solange aufrechterhalten wird, bis der abgedeckte Bereich aus dem Lotbad entfernt und damit eine Verbindung der eingeschlossenen, definierten Lotvolumina mit dem im Tauchbad verbleibenden flüssigen Lot nicht mehr besteht.

Es hat sich überraschenderweise gezeigt, daß es auch möglich ist, die Lotvolumina in noch nicht erstarrtem Zustand aufzudecken, sie erstarren dann in einer Zwischenphase in einer Form, die von der Raumlage der Platine und von der Oberflächenspannung abhängig ist. Dies bedeutet, daß sich kleine runde Höcker bilden, deren Höhe etwas größer ist als die Höhe der umgebenden Beschichtung. In besonders vorteilhafter Weise stellt sich dabei als Zusatzeffekt ein, daß im Bereich der Abdichtung verquetschtes Lotmaterial in das Lotvolumen zurückgezogen wird und damit eine Brückenbildung zwischen einzelnen Lotpads verhindert wird, die für die Schaltung nachteilige Folgen haben würden.

An dem verbesserten Verfahren ist weiterhin von Vorteil, daß für die Einebnung der Lotvolumina gesonderte Materialien verwendet werden können, die sich von dem eigentlichen Abdichtungsmaterial unterscheiden. Die Formungsmaterialien brauchen nicht unmittelbar in das Lotbad eingetaucht zu werden und sind demnach nicht ständig einer sehr hohen Temperatur ausgesetzt. Die zum Einebnen der Lotvolumina notwendige erneute Erwärmung der erstarrten Lotvolumnia kann gezielt und sehr vorsichtig geschehen, so daß der Formungsprozeß unterschiedlichen Anforderungen angepaßt werden kann.

Gemäß Anspruch 2 kann es auch vorteilhaft sein, die Leiterplatte nach dem erstmaligen Erstarren der Lotvolumina einem Reinigungsvorgang zu unterziehen. Dabei können Flußmittel ausgewaschen werden, die sich im Bereich der Beschichtung gebildet haben und die beim nachfolgenden Formungsprozeß ebenfalls zu einer Brückenbildung beitragen könnten.

Das Abschlußelement hat lediglich noch die Aufgabe, eine möglichst genaue Definition der Lotvolumina herzustellen, das Abdichtelement muß nicht längerfristig auf den Lotpads verbleiben, weswegen sehr einfach ausgebildete Abschlußelemente zur Durchführung des Verfahrens herangezogen werden können, die beispielsweise die Leiterplatten- bzw. die Beschichtungsoberfläche streifend beaufschlagen können und dabei die notwendige kurzzeitige Trennung zwischen definiertem Lotvolumen und im Lotbad verbleibenden Lot bewirken.

Es ist auch möglich, als Abschlußelement eine einfache Rolle heranzuziehen, die die Leiterplatten- oder Beschichtungsoberfläche abrollend beaufschlagt. Sobald das definierte Lotvolumen aus der Lotbadoberfläche herausgetreten ist oder auf sonstige Weise aus dem Lotbad herausgebracht wurde (seitlich durch eine Art Abdichtschleuse) kann der abgedeckte Bereich quasi wieder "aufgedeckt" werden, der erste Loterstarrungsprozeß unter Kuppelbildung des Lotes aufgrund der Oberflächenspannung ungestört vor sich gehen.

Es kann auch vorteilhaft sein, die definierten Lotvolumina im offenen Zustand noch einmal kurz über die Schmelztemperatur hochzuheizen, da dann über den Hohlraumbereich hinausstehende verfestigte Lotrückstände sicher in den Hohlraumbereich zurückkontrahiert werden oder aber durch geeignete Maßnahmen von der Beschichtungsoberfläche entfernt werden können.

3

Die Abschlußelemente können zum einen im Bereich des Lotbadspiegels angeordnet sein, es läßt sich aber auch eine Entnahme der Leiterplatten aus dem Lotbad unterhalb des Lotbadspiegels durch eine Lotbadseitenwandung mit Abdeckelementen vornehmen.

Wenn die mit den Hohlräumen versehene Leiterplattenoberfläche horizontal liegt, bilden sich aufgrund der Schwerkraft die erstarrenden Lotkuppeln symmetrisch aus, was für den nachfolgenden Formungsvorgang vorteilhaft ist.

Das Formelement, das von dem Abdeckelement gesondert ausgebildet ist, kann eine Formwalze sein, es können aber auch oszillierende Formwalzensegmente, ein Formungsband oder beispielsweise Formungsstempel verwendet werden, die im Falle einer fortlaufenden Fertigung einen gewissen Abschnitt der Fertigungsstraße zusammen mit den Platinen formgebend mitlaufen.

In vorteilhafter Weise kann der Formgebungsprozeß durch zumindest teilweise oder zeitweise Beheizung der Formelemente positiv beeinflußt werden. Ist das Formgebungselement als Förderband ausgebildet, bietet sich an, unterschiedliche Temperaturzonen im Förderbereich vorzusehen. Werden zur Formgebung hingegen Formstempel herangezogen, so können sie kurzzeitig aufgeheizt über $\vartheta_{sm}$ und dann mit Kühlmitteln gezielt wieder unter $\vartheta_{Er}$ heruntergekühlt werden.

Die Vorrichtung nach einem der Ansprüche 16 ff. ist dadurch gekennzeichnet, daß die Abdeckvorrichtung die zur Belotung vorgesehenen Bereiche der Leiterplatte nur während des Austauchvorganges selbst abdeckt und zur Formgebung der Lotoberflächen eine gesonderte Formvorrichtung vorgesehen ist, die in vorteilhafter Weise räumlich getrennt von der Abdeckvorrichtung angeordnet sein kann.

Ganz besonders vorteilhaft ist es, wenn die Vorrichtung als eine Fertigungsstraße ausgebildet ist, die folgende Fertigungsstationen aufweist:

- eine Platineneingabevorrichtung, an der die Platinen auf ein Förderband gegeben und in die Transportstraße eingeführt werden;
- einen Lotbehälter, in den die vorbereiteten Leiterplatten zur Belotung eingeführt und unter Abdichtung mittels Abdichtelementen wieder ausgeführt werden sowie
- einer in Transportrichtung nachgeordneten Formvorrichtung, an deren Ende in Transportrichtung eine Platinenausgabestation angeordnet ist.

Die einzelnen Stationen können in einer Ebene nacheinander angeordnet sein, es läßt sich zusätzlich noch eine Reinigungsvorrichtung vorsehen, in der zwischen Lotvolumendefinition und Formungsvorgang an den Platinen ein Reinigungsvorgang abläuft.

Weitere vorteilhafte Merkmale ergeben sich aus den nachfolgenden Unteransprüchen.

Die Erfindung ist anhand von Ausführungsbeispielen in den Zeichnungsfiguren näher erläutert. Diese zeigen:

Fig. 1      ein Ablaufschema des erfindungsgemäßen Verfahrens;

Fig. 2      einen schematischen Schnitt durch eine Vorrichtung zur Durchführung des Verfahrens, bei der die Platinen in senkrechter Stellung aus dem Lotbad ausgetaucht und geformt werden;

Fig. 3      eine weitere Darstellung entsprechend Fig. 2, bei welcher die Platinen senkrecht aus dem Lotbad ausgetaucht und in waagerechter Stellung geformt werden;

Fig. 4      eine schematische Schnittdarstellung einer modifizierten Vorrichtung, die in einer Durchlaufanlage einsetzbar ist;

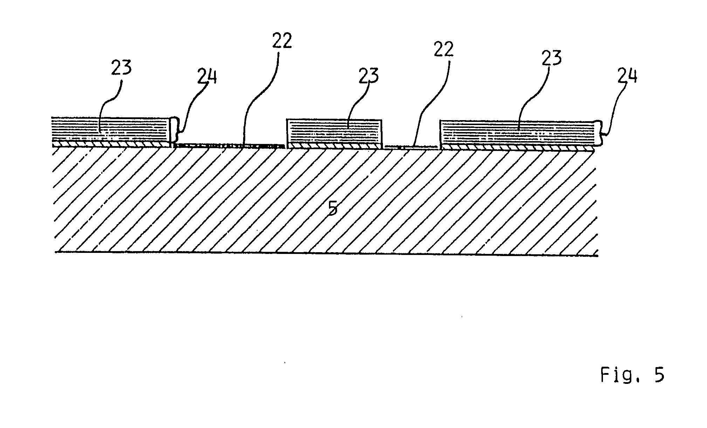

Fig. 5      einen Schnitt durch eine Leiterplatte vor dem Eintauchen nach dem Auftragen und Belichten der temporären Lötstoppmaske sowie Freilegen der SMD-Lötflächen in das Lotbad;

Fig. 6      eine schematische Schnittdarstellung durch eine Leiterplatte eingetaucht in ein Lotbad;

Fig. 7      eine schematische Schnittdarstellung durch eine in ein Lotbad eingetauchte Leiterplatte, wobei die Kavitäten mit flüssigem Lot gefüllt und von einem Abschlußelement abgedeckt werden;

Fig. 8      eine schematische Schnittdarstellung mit erstarrten, ungeformten Lotvolumina;

Fig. 9      eine schematische Schnittdarstellung durch eine Leiterplatte nach dem Formungsvorgang sowie

Fig. 10      eine schematische Schnittdarstellung durch eine Leiterplatte im Endzustand nach Entfernung der temporären Lotstoppmaske.

Fig. 11      eine schematische Schnittdarstellung einer modifizierten Vorrichtung mit einer geschlossen Lotkammer;

Fig. 12      eine schematische Schnittdarstellung einer modifizierten Vorrichtung, bei der die Lotkammer als Düsenstock ausgebildet ist.

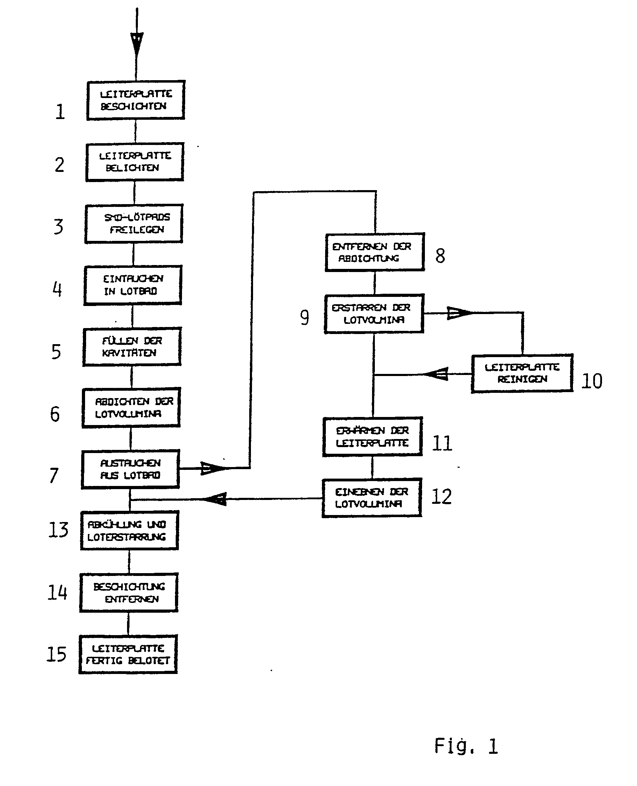

Das Ablaufschema des erfindungsgemäßen Verfahrens gemäß Fig. 1 weist 15 einzelne Verfahrensschritte auf.

4

Als erster Verfahrensschritt wird zunächst die Leiterplatte in üblicher Weise beschichtet und im zweiten Schritt die Leiterplatte belichtet, sodann erfolgt als dritter Verfahrensschritt eine Freilegung der SMD-Lotpads, ebenfalls ein bekannter Verfahrensschritt bei der Leiterplattenherstellung.

Die so vorbereitete Leiterplatte wird beim vierten Verfahrensschritt in ein Lotbad eingetaucht, dies kann sowohl durch den Lotbadspiegel geschehen, es ist aber auch möglich, das Eintauchen der Leiterplatten durch eine Einführungsschleuse vorzunehmen, die in einer Seitenwandung des Lotbehälters unterhalb des Lotbadspiegels angeordnet ist und entsprechende Lotdichtungen und Lotauffangelemente für durch die Schleuse austretendes flüssiges Lot aufweist.

Im Lotbad füllen sich die Kavitäten über den SMD-Lotpads mit flüssigem Lot, erforderlichenfalls können Turbulenzhilfen eingesetzt werden, um sicherzustellen, daß sich auch Kavitäten über kleinflächigen Lötpads komplett füllen.

Der nächste Schritt besteht darin, die in den Kavitäten befindlichen Lotvolumina gegenüber dem im Lotbad befindlichen flüssigen Lot abzudichten, was durch ein Abdichtelement geeigneter Form geschieht. Gemäß Verfahrensschritt sieben wird sodann die Leiterplatte aus dem Lotbad ausgetaucht, wobei dafür Sorge zu tragen ist, daß die gerade das Lotbad verlassenden Kavitäten abgedichtet sind. Es ist nicht notwendig, die gesamte Leiterplatte abzudichten, für das Verfahren ist ausreichend, eine Abdichtung der gerade aus dem Lotbad austretenden Kavitäten sicherzustellen, so daß eine Lotvolumendefinition innerhalb der Kavitäten erfolgt. Sobald die Trennung zwischen definiertem Lotvolumen und Lotbad vollzogen ist, kann die Abdichtung wieder gelöst werden, aufgrund der Oberflächenspannung bleibt das definierte Lotvolumen am Boden der Kavität, d. h. auf dem SMD-Lotpads haften und bildet nach dem Entfernen der Abdichtung gemäß Verfahrensschritt acht aufgrund der Oberflächenspannung und der Raumlage der Platine eine Kuppel, die dann gemäß Verfahrensschritt zwölf von gesonderten Formelementen eingeebnet oder plattgedrückt wird, so daß das Lotvolumen sich an die Form der Kavität anpaßt. Nach einer Abkühlung können die Formelemente entfernt werden, ferner kann gemäß Verfahrensschritt vierzehn die Beschichtung entfernt werden, die Leiterplatte ist fertig belotet.

Optional ist es möglich, zwischen dem Austauchvorgang und dem Entfernen der Abdichtung gemäß Verfahrensschritten sieben und acht als Verfahrensschritt neun zunächst die Lotvolumina in der Kuppelform erstarren zu lassen. Falls dies der Fall ist, muß gemäß Verfahrensschritt elf vor der Einebnung der Lotvolumina gemäß Verfahrensschritt zwölf eine erneute Erwärmung der Leiterplatten erfolgen.

Optional ist es ferner möglich, zwischen den Verfahrensschritten neun und elf die Leiterplatte gemäß Verfahrensschritt zehn einem Reinigungsvorgang zu unterziehen.

Die in Zeichnungsfig. 2 dargestellte Vorrichtung zur Durchführung des Verfahrens besteht i. w. aus einem Lotbehälter 1, der mit flüssigem Lot 2 gefüllt ist. Ferner ist eine nur angedeutete Transportvorrichtung 3 mit einem motorischen Antrieb 4 vorgesehen, mit der die Leiterplatte 5 in das Lot 2 eingetaucht werden kann. Mit 6 ist eine Abdeckvorrichtung bezeichnet, die dazu geeignet ist, unterhalb des Lotspiegels 7 zur Belotung vorgesehene, durch eine Begrenzungsschicht 23 umgrenzte Bereiche (SMD-Lotpads 22) der Leiterplatte 5 abzudecken. Die Abdeckvorrichtung 6 ist so ausgebildet, daß die zur Belotung vorgesehenen Bereiche der Leiterplatte 5 nur während des Durchtretens durch den Lotbadspiegel 7 abgedeckt werden, zur Formgebung der Lotoberflächen ist sodann eine gesonderte Formvorrichtung 8 vorgesehen, mit der die Verfahrensschritte zwölf und dreizehn, ggf. auch Verfahrensschritt elf gemäß Fig. 1 vollzogen werden können.

Bedeutungsvoll ist, daß Abdeckvorrichtung 6 und Formvorrichtung 8 gesonderte Elemente sind, die auch räumlich getrennt voneinander angeordnet sein können.

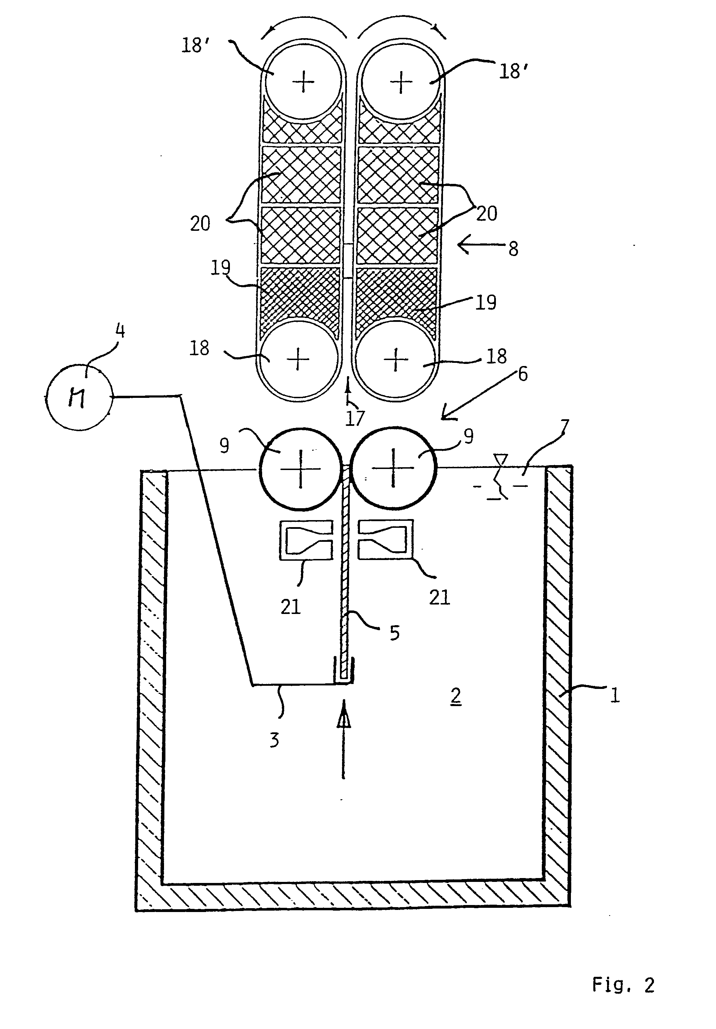

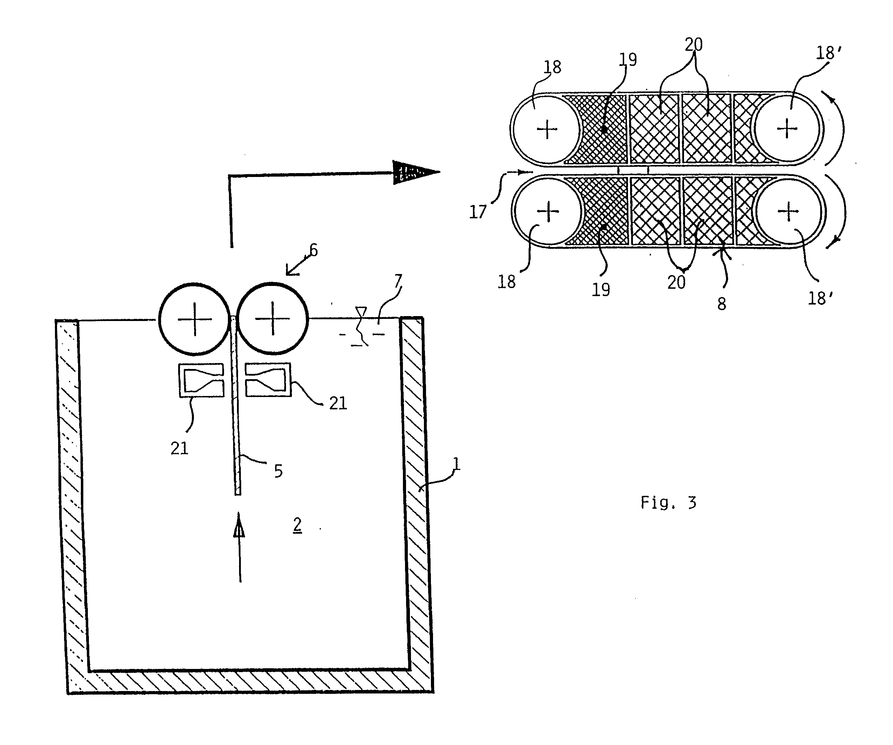

Die Abdeckvorrichtung 6 besteht in Fig. 2 und 3 aus Abdichtrollen 9, deren Achsen etwa in der Höhe des Lotspiegels 7 angeordnet sind. Aufgrund der Elastizität der Abdichtrollen 9 wird im Moment des Durchtrittes der Kavitäten durch den Lotspiegel 7 eine vollständige Trennung zwischen den definierten Lotvolumina 25 und dem Lot 2 im Lotbehälter 1 erreicht, so daß die Kavitäten nach Austritt aus dem Abdichtrollenpaar wieder aufgedeckt werden können, ohne daß eine Veränderung des Lotvolumens in den Kavitäten stattfindet.

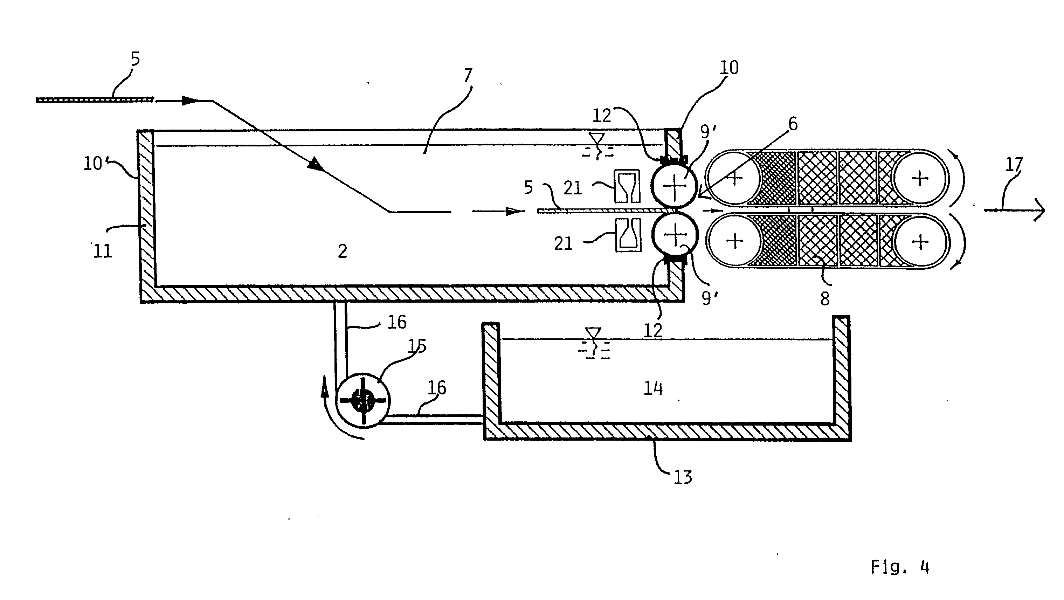

Wie in Zeichnungsfig. 4 zu sehen ist, können die Abdichtrollen 9 auch in einer Seitenwandung 10 eines Lotbehälters 11 angeordnet sein, zwischen den Seitenwandungsabschnitten und den Abdichtrollen 9 können weitere Abdichtelemente 12 angeordnet sein, die einen allzu heftigen Lotausfluß im Bereich der so gebildeten Schleuse verhindern. Da aber jedenfalls beim Durchtritt der Leiterplatten 5 mit einem Ausfluß flüssigen Lotes 2 aus dem Lotbehälter 11 zu rechnen ist, ist ein beheizter Auffangbehälter 13 vorgesehen, in dem das austretende Lot 14 aufgefangen, flüssig gehalten und über eine Lotpumpe 15, die in einer Lotleitung 16 angeordnet ist, in den Lotbehälter 11 zurückgepumpt wird. Bei dem in Fig. 4 dargestellten Ausführungsbeispiel wird die Einführung der Leiterplatte 5 durch den Lotspiegel 7 vollzogen, es ist aber ebenso möglich, beispielsweise die der Seitenwandung 10 gegenüberliegende Seitenwandung 10' mit einer Schleuse zu versehen, durch die die Leiterplatte 5 unterhalb des Lotspiegels 7 in das Lot 2 eingeführt wird. Eine Einführungsschleuse ist i. w. genauso auszubilden wie die Abdeckvorrichtung 6.

In Transportrichtung 17 ist der Abdeckvorrichtung 6 die Formvorrichtung 8 nachgeschaltet, die entsprechend den Formvorrichtungen 8 gemäß Fig. 2 und 3 ausgebildet sein kann.

Die Vorrichtung gemäß Fig. 3 unterscheidet sich von der in Fig. 2 dargestellten lediglich dadurch, daß die Leiterplatte 5 nach dem Austauchen flach gelegt wird und in flachem Zustand in den Formgebungsprozeß gefahren wird.

Die Formvorrichtungen 8 sind als Förderbandanordnung ausgebildet, wobei es möglich ist, daß zwischen den Bandrollen 18, 18' unterschiedliche Temperaturzonen dadurch gebildet werden, daß im Einführungsbereich der Formvorrichtung 8 nicht näher dargestellte Heizelemente 19 vorgesehen sind, denen sich in Transportrichtung 17 Kühlzonen 20 anschließen.

Im Lot 2 können vor der Abdeckvorrichtung 6 ferner Lotturbulenzdüsen 21 angeordnet sein, die für eine turbulente Bewegung im Lotbereich vor der Abdeckvorrichtung 6 sorgen und dazu mit nicht näher dargestellten Lotpumpen 15 in Verbindung stehen.

Die in Zeichnungsfig. 5 - 10 dargestellten schematischen Schnitte durch eine Leiterplatte 5 werden in bezug auf das Ablaufschema gemäß Fig. 1 erläutert.

Die in Zeichnungsfig. 5 dargestellte Leiterplatte 5 weist freigelegte SMD-Lotpads 22 auf, die von einer Beschichtung 23 umgeben sind, deren Höhe 24 der Höhe des aufzubringenden Lotauftrages i. w. entspricht. Näheres ergibt sich aus der europäischen Patentanmeldung EP-OS 0 336 232, auf die ausdrücklich verwiesen wird. Die so ausgebildete Leiterplatte 5 ist Ergebnis der Verfahrensschritte eins bis drei gemäß Fig. 1.

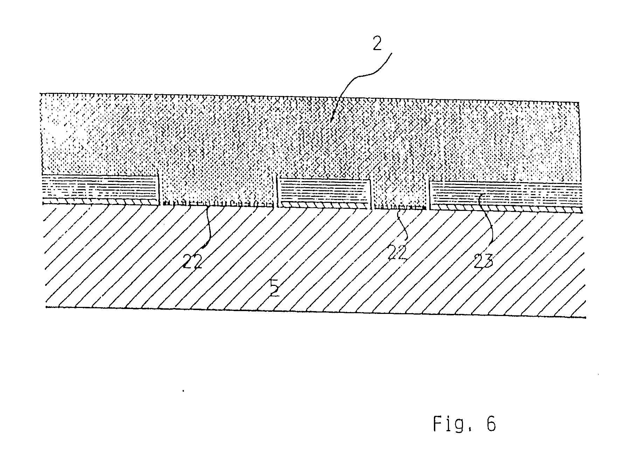

In Fig. 6 ist die so vorbereitete Leiterplatte 5 nun in das Lot 2 eingetaucht, ggf. unter Zuhilfenahme der Turbulenzdüsen 21 wird das Lot 2 vollständig die Kavitäten über den SMD-Lotpads 22 ausfüllen. Die Darstellung gemäß Fig. 6 entspricht i. w. den Verfahrensschritten vier und fünf gemäß Fig. 1.

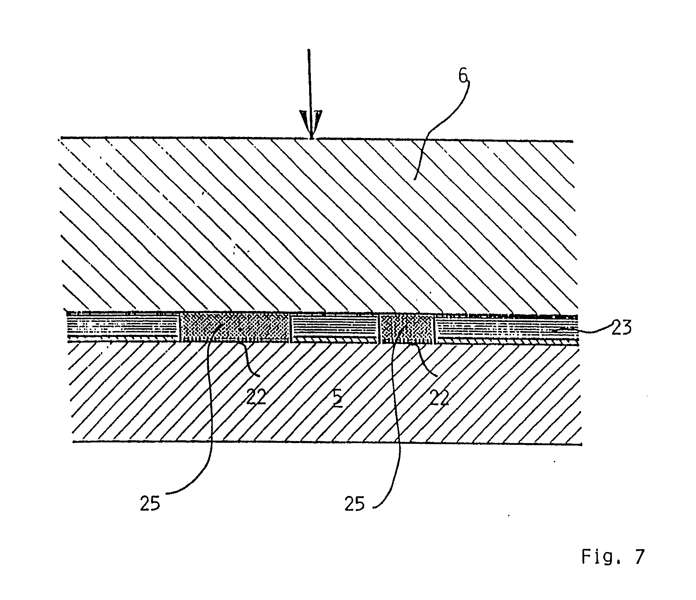

In Fig. 7 ist nun die eingetauchte Leiterplatte 5 mit der Abdeckvorrichtung 6 abgedeckt, in den Kavitäten werden Lotvolumina 25 definiert, die von dem im Lotbehälter 1 verbleibenden Lot 2 durch die Abdeckvorrichtung 6 getrennt sind. In diesem Zustand wird die Leiterplatte 5 aus dem Lotbad herausgenommen. Die schematische Darstellung gemäß Fig. 7 entspricht i. w. den Verfahrensschritten sechs und sieben gemäß Fig. 1.

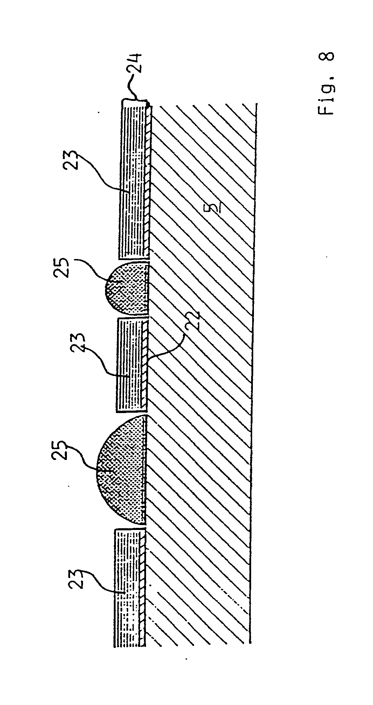

Nachdem die Abdeckvorrichtung 6 entfernt ist, werden die Lotvolumina 25, die in Fig. 8 dargestellte Form einnehmen, die schematische Darstellung gemäß Fig. 8 entspricht somit i. w. dem Verfahrensschritt acht und neun gemäß Fig. 1. Es sei darauf hingewiesen, daß die Erstarrung der Lotvolumina 25 vor dem Einebnen der Lotvolumina 25 gemäß Verfahrensschritt zwölf in Fig. 1 nicht notwendigerweise erfolgen muß, es ist auch möglich, die noch flüssigen kuppelförmigen Lotvolumina 25 mit der Formvorrichtung 8 einzuebnen, die auch wiederum aus einem Abdeckelement geeigneter Form bestehen kann.

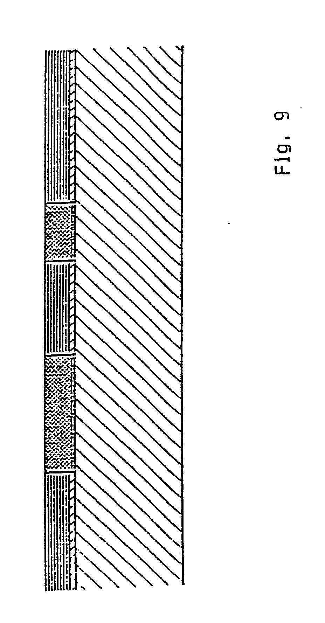

In Fig. 9 ist der Einebnungsprozeß gemäß Verfahrensschritt zwölf in Fig. 1 und der Abkühlungsprozeß gemäß Verfahrensschritt dreizehn in Fig. 1 abgeschlossen.

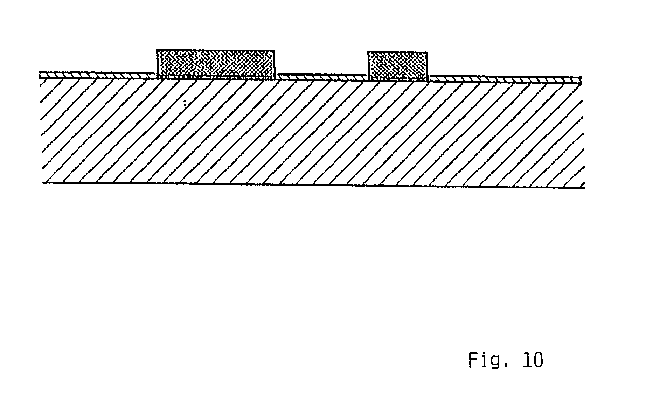

Fig. 10 zeigt die fertig belotete Leiterplatte 5, wie sie sich nach Durchführung des Verfahrensschrittes vierzehn (Entfernung der Beschichtung 23 gemäß Verfahrensschritt fünfzehn gemäß Fig. 1) ergibt.

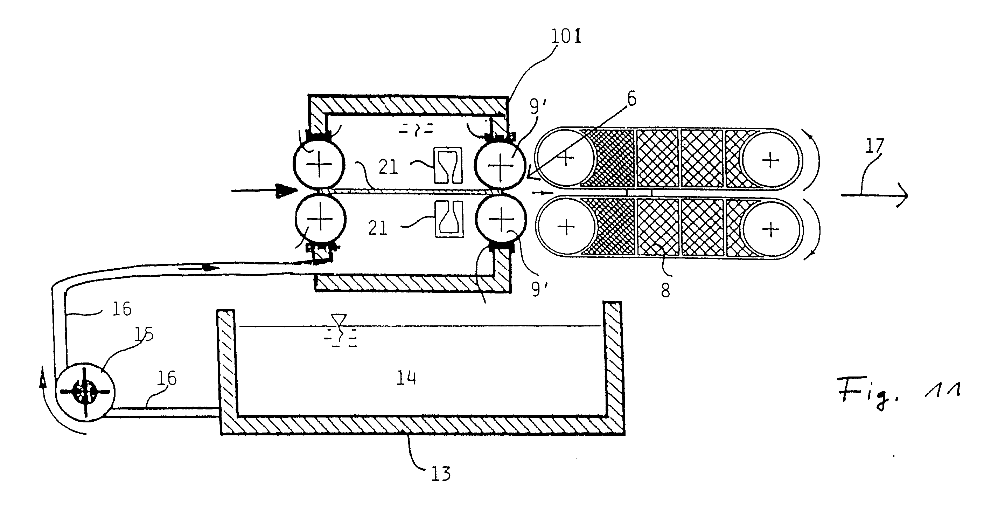

Fig. 11 zeigt eine schematische Schnittdarstellung einer modifizierten Anlage mit einer geschlossenen Lotkammer. Im wesentlichen entspricht die Vorrichtung gemäß Fig .11 der in Fig. 4 gezeigten, jedoch wird die Leiterplatte durch ein Abdichtrollenpaar in eine geschlossene Lotkammer eingefahren, dort einweder ganzflächig oder abschnittsweise mit flüssigem Lot beidseitig benetzt und auf der anderen Seite durch das Rollenpaar 9' wieder ausgefahren. Das "Eintauchen" in das flüssige Lot geschieht somit unterhalb des Lotspiegels.

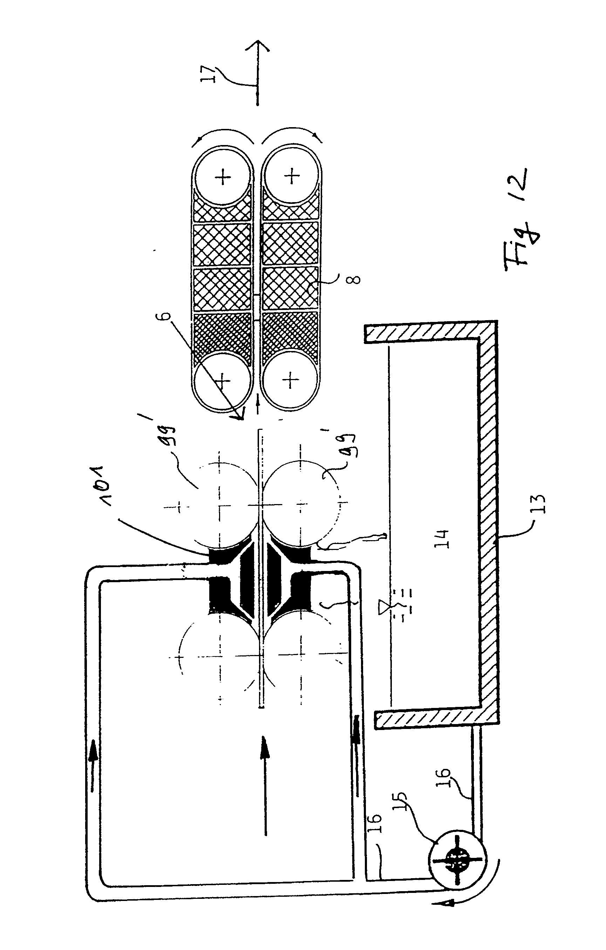

Fig. 12 zeigt eine Vorrichtung ähnlich wie Fig. 11, allerdings ist die Lotkammer als zwischen dem Einführungs- und Abdichtrollenpaar angeordnete Düsenstockanordnung ausgebildet. Die Leiterplatte wird beidseitig mit unter Druck in den Düsenstock eingeleiteten flüssigen Lot beaufschlagt, das Lot wird durch das Abdichtrollenpaar 99' abgequetscht, so daß es nur in vorgesehenen Kavitäten über den Lötpads verbleibt.

Die Formgebung des Düsenstocks ist so gewählt, daß ein Lotfluß in den Zwickel der Rollenpaare hinein vorherrscht, wodurch sich besonders gute Belotungsergebnisse erzielen lassen.

Bei Figuren 11 und 12 ist gemeinsam, daß überflüssiges Lot aus den Rollenpaaren heraus in einem Auffangbehälter 13 fällt, der beheizt ist. Über eine Leitung 16 und eine Pumpe 15 wird flüssiges Lot in die Lotkammer bzw. in den Lotdüsenstock gedrückt und steht dort unter Druck zum Belotungsvorgang zur Verfügung.

## BEZUGSZEICHENLISTE

1 Lotbehälter

2 Lot

3 Transportvorrichtung

4 Antrieb

5 Leiterplatte

6 Abdeckvorrichtung

7 Lotspiegel

8 Formvorrichtung

9 Abdichtrolle

10 Seitenwandung

10' "

11 Lotbehälter

12 Abdichtelemente

13 Auffangbehälter

14 Lot

15 Lotpumpe

16 Lotleitung

17 Transportrichtung

18 Bandrollen

18' "

19 Heizelemente

20 Kühlzone

21 Lotturbulenzdüsen

22 SMD-Lotpads

23 Beschichtung

24 Höhe

25 Lotvolumina

**Patentansprüche**

1. Verfahren zum Beloten von Leiterplatten mit dem Ablauf folgender Verfahrensschritte:
   a) Herstellen einer Leiterplatte mit elektrisch leitfähigen Bereichen (Lötpads), die mit einem Lotauftrag zu versehen sind;
   b) Vorsehen einer diese Bereiche umgrenzenden, eine Belotung verhindernden Beschichtung definierter Schichtdicke;
   c) Eintauchen oder abschnittweises Einbringen der so vorbereiteten Leiterplatte in ein Lotbad oder eine Lotkammer mit geeigneter Lotlegierung;
   d) Abdecken der über den zu belotenden Bereichen liegenden, im Tauchbad oder der Lotkammer mit flüssigem Lot gefüllten Hohlräume in der Weise, daß die Abedeckung beim Austauchen bzw.

Ausbringen eine Trennung der eingeschlossenen Lotvolumina von dem im Tauchbad oder der Lotkammer befindlichen flüssigen Lot vornimmt und dabei in den Hohlräumen entsprechende Lotvolumina definiert werden;

e) Austauchen oder Ausbringen der zumindest teilweise abgedeckten Leiterplatte, Entfernung der Abdichtung von den Bereichen erst dann, wenn die definierten Lotvolumina mit dem im Tauchbad verbleibenden flüssigen Lot nicht mehr in Berührung kommen können;

f) gegebenenfalls Erstarrung der Lotvolumina in einer Form, die abhängig von der Oberflächenspannung, der Leiterplattenraumlage und der Größe des Lotvolumens ist;

g) gegebenenfalls erneute Erwärmung der erstarrten Lotvolumina;

h) Einebnen der Lotvolumina durch Beaufschlagung mit einem Formelement;

i) Abkühlung und Loterstarrung unter Einfluß des Formelementes;

j) Entfernen der Begrenzungsschicht.

2. Verfahren nach Anspruch 1,

dadurch gekennzeichnet,

daß die Leiterplatte nach dem erstmaligen Erstarren der Lotvolumina gem. Verfahrensschritt f) einem Reinigungsvorgang unterzogen wird.

3. Verfahren nach Anspruch 1 oder 2,

dadurch gekennzeichnet,

daß das Formelement als gesondertes Abdichtelement ausgebildet ist.

4. Verfahren nach Anspruch 1 - 3,

dadurch gekennzeichnet,

daß das Abschlußelement die Leiterplattenoberfläche oder Beschichtungsoberfläche streifend beaufschlagt.

5. Verfahren nach einem der vorhergehenden Ansprüche,

dadurch gekennzeichnet,

daß das Abschlußelement die Leiterplattenoberfläche oder Beschichtungsoberfläche abrollend beaufschlagt.

6. Verfahren nach einem der vorhergehenden Ansprüche,

dadurch gekennzeichnet,

daß die Lotvolumina nach Beendigung des Abschlußvorganges im offenen Zustand über die Schmelztemperatur aufgeheizt werden und dabei über den Hohlraumbereich hinausstehende verfestigte Lotrückstände in den Hohlraumbereich kontrahiert werden.

7. Verfahren nach Anspruch 6,

dadurch gekennzeichnet,

daß die Zwischenaufheizung durch Strahlungsheizung erfolgt.

8. Verfahren nach einem der vorhergehenden Ansprüche,

dadurch gekennzeichnet,

daß das Austauchen der Leiterplatte aus dem Lotbad mit Abschlußelementen erfolgt, die im Bereich des Lotbadspiegels angeordnet sind.

9. Verfahren nach einem der vorhergehenden Ansprüche,

dadurch gekennzeichnet,

daß das Austauchen der Leiterplatte aus dem Lotbad unterhalb des Lotbadspiegels durch eine Lotbadseitenwandung mit Abdeck-/Abdichtelementen erfolgt.

10. Verfahren nach einem der vorhergehenden Ansprüche,

dadurch gekennzeichnet,

daß das Austauchen der Leiterplatte derart erfolgt, daß die mit den Hohlräumen versehene Leitplattenoberfläche nach unten weist.

11. Verfahren nach einem der vorhergehenden Ansprüche,

dadurch gekennzeichnet,

daß das Formelement als ggf. elastische Formwalze ausgebildet ist.

12. Verfahren nach einem der vorhergehenden Ansprüche,

dadurch gekennzeichnet,

daß das Formelement als oszillierendes Formwalzensegment ausgebildet ist.

13. Verfahren nach einem der vorhergehenden Ansprüche,

dadurch gekennzeichnet,

daß das Formelement als Formungsband (Förderband) ausgebildet ist.

14. Verfahren nach einem der vorhergehenden Ansprüche,

dadurch gekennzeichnet,

daß das Formelement zumindest teilweise gekühlt ist.

15. Verfahren nach einem der vorhergehenden Ansprüche,

dadurch gekennzeichnet,

daß bei einem als Durchlaufelement ausgebildeten Formelement zunächst mindestens eine Heiz- und nachfolgend mindestens eine Kühlzone vorgesehen ist.

16. Vorrichtung zum Tauchbeloten von Leiterplatten mit einer den Lotauftrag seitlich definierenden Begrenzungsschicht mit
- einem Lotbehälter (1) oder einer Lotkammer (101) mit flüssigem Lot (2);
- einer Transportvorrichtung (3), mit der die Leiterplatte (5) in den Lotbehälter (1) eintauchbar bzw. einbringbar ist sowie
- einer Abdeckvorrichtung (6), mit der unterhalb des Lotspiegels (7) zur Belotung vorgesehene, durch die Begrenzungsschicht (23) umgrenzte Bereiche (SMD-Lotpads 22) abgedichtet werden können,

dadurch gekennzeichnet,

9

daß die Abdeckvorrichtung (6) derart ausgebildet ist, daß die zur Belotung vorgesehenen Bereiche (SMD-Lotpads 22) der Leiterplatte (5) nur während des Austauchvorganges bzw. des Ausbringungsvorganges abgedeckt sind und zur Formgebung der Lotoberflächen eine gesonderte Formvorrichtung (8) vorgesehen ist.

17. Vorrichtung nach Anspruch 16,

dadurch gekennzeichnet,

daß die Formvorrichtung (8) räumlich getrennt von der Abdeckvorrichtung (6) angeordnet ist.

18. Vorrichtung nach einem der vorhergehenden Ansprüche 16 oder 17,

dadurch gekennzeichnet,

daß die Abdeckvorrichtung (6) mindestens eine Abdichtrolle (9) aufweist.

19. Vorrichtung nach einem der vorhergehenden Ansprüche,

dadurch gekennzeichnet,

daß die mindestens eine Abdichtrolle (9) im Bereich des Lotspiegels (7) angeordnet ist.

20. Vorrichtung nach einem der vorhergehenden Ansprüche,

dadurch gekennzeichnet,

daß die mindestens eine Abdichtrolle (9) zusammen mit weiteren Abdichtelementen (12) in einer Seitenwandung (10) des Lotbehälters (1) oder der Lotkammer unterhalb des Lotspiegels (7) angeordnet ist.

21. Vorrichtung nach einem der vorhergehenden Ansprüche,

dadurch gekennzeichnet,

daß in Transportrichtung (17) die Formelemente (8) unmittelbar nach der Abdichtvorrichtung angeordnet sind.

22. Vorrichtung nach einem der vorhergehenden Ansprüche

dadurch gekennzeichnet,

daß der Lotbehälter (1) oder die Lotkammer unterhalb des Lotspiegels (7) auf einer ersten Seite mit zur Platinenführung geeigneten, ersten Dichtelementen und auf einer gegenüberliegenden Seite mit zur Platinenausführung geeigneten weiteren Dichtelementen versehen ist, welch letztere die Abdeckvorrichtung (6) beinhalten oder bilden.

23. Vorrichtung nach einem der vorhergehenden Ansprüche,

dadurch gekennzeichnet,

daß unterhalb der Abdichtelemente (12) ein Auffanglotbehälter (13) angeordnet ist.

24. Vorrichtung nach einem der vorhergehenden Ansprüche,

dadurch gekennzeichnet,

daß die Formelemente als i. w. horizontal verlaufende Förderbandanordnungen ausgebildet sind.

25. Vorrichtung nach einem der vorhergehenden Ansprüche,

gekennzeichnet durch

eine Fertigungsstraße mit folgenden Fertigungsstationen:
a) eine Platineneingabevorrichtung, an der die Platinen auf ein Förderband gegeben und in die Transportstraße eingeführt werden
b) mindestens einen Lotbehälter, in den die vorbereiteten Leiterplatten zur Belotung eingeführt und unter Abdichtung mittels Abdichtelementen ausgeführt werden

sowie
c) einer in Transportrichtung nachgeordneten Formvorrichtung, an deren Ende in Transportrichtung eine Platinenausgabestation angeordnet ist.

26. Vorrichtung nach Anspruch 25,

dadurch gekennzeichnet,

daß zwischen der Abdeckvorrichtung (6) und der Formvorrichtung (8) eine Reinigungsvorrichtung zur Reinigung der mit ungeformten Lotaufträgen versehenen Platine angeordnet ist.

27. Vorrichtung nach einem der vorhergehenden Ansprüche,

dadurch gekennzeichnet,

daß zwischen der Abdeckvorrichtung (6) des Lotbehälters (1) und den Formungselementen eine Heizvorrichtung (Strahlungsheizung, Heißluftlineal oder dgl.) angeordnet ist.

28. Vorrichtung nach einem der vorhergehenden Ansprüche,

dadurch gekennzeichnet,

daß im Lotbehälter (1) in Transportrichtung (17) vor der Abdeckvorrichtung (6) Lotturbulenzdüsen (21) vorgesehen sind.

29. Leiterplatte,

dadurch gekennzeichnet,

daß sie nach dem Verfahren nach einem der Ansprüche 1 - 15 hergestellt ist.

Fig. 1

Fig. 2

Fig. 3

Fig. 4

EP 0 457 346 A1

Fig. 5

EP 0 457 346 A1

Fig. 6

Fig. 7

Fig. 8

Fig. 9

Fig. 10

Fig. 11

Fig 12

EP 0 457 346 A1

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| D,A | EP-A-0 336 232  (FRIEDRICH ET AL.)<br>* das ganze Dokument * | 1-29 | H 05 K 3/34 |
| A | WO-A-9 005 041  (MOTOROLA.INC)<br>* Seite 3, Zeilen 17 - 35; Figuren 4-6 * | 1,16 | |
| A | IBM TECHNICAL DISCLOSURE BULLETIN. vol. 32, no. 1, Juni 1989, NEW YORK US Seiten 50 - 51; "leveling technique for pads of predeposited solder"<br>* das ganze Dokument * | 1,16 | |
| | | | RECHERCHIERTE SACHGEBIETE (Int. Cl.5) |
| | | | H 05 K<br>B 23 K |

Der vorliegende Recherchenbericht wurde für alle Patentansprüche erstellt

| Recherchenort | Abschlußdatum der Recherche | Prüfer |
|---|---|---|
| Berlin | 28 August 91 | CLOSA D. |